(19) Europäisches Patentamt
European Patent Office
Office européen des brevets

(11) Veröffentlichungsnummer: **0 194 587**
**A2**

(12) # EUROPÄISCHE PATENTANMELDUNG

(21) Anmeldenummer: **86102977.5**

(22) Anmeldetag: **06.03.86**

(51) Int. Cl.⁴: **G 03 F 7/08**

(30) Priorität: **15.03.85 DE 3509383**

(43) Veröffentlichungstag der Anmeldung:
**17.09.86 Patentblatt 86/38**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Uhlig, Fritz, Dr. Dipl.-Chem.**
**Weinfeldstrasse 1**
**D-6200 Wiesbaden(DE)**

(72) Erfinder: **Hübel, Monika**
**Riehlstrasse 5**
**D-6200 Wiesbaden(DE)**

(72) Erfinder: **Sand, Raimund**
**Rhönstrasse 1**
**D-6229 Walluf(DE)**

(54) **Lichtempfindliches Diazoniumsalz-Polykondensationsprodukt und damit hergestelltes lichtempfindliches Aufzeichnungsmaterial.**

(57) Es wird ein lichtempfindliches Polykondensationsprodukt aus wiederkehrenden Einheiten der Formeln $A_1$ und $A_2$

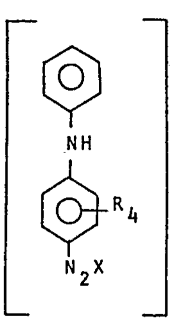

($A_1$)

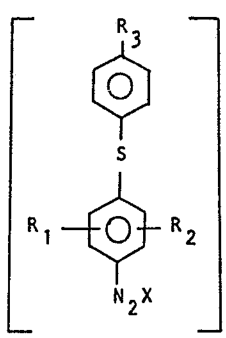

($A_2$)

beschrieben, die durch Methylengruppen miteinander verbunden sind, wobei

$R_1$ und $R_2$ Alkoxygruppen mit 1 bis 4 Kohlenstoffatomen,
$R_3$ ein Wasserstoffatom oder eine Alkylgruppe und
$R_4$ ein Wasserstoffatom oder eine Alkoxygruppe mit 1 bis 4 Kohlenstoffatomen bedeuten,
$A_1 : A_2$ 0,125 bis 8 : 1 beträgt und X das Anion einer Fluoratome enthaltenden Säure ist. Das Kondensationsprodukt wird zur Herstellung von lichtempfindlichem Aufzeichnungsmaterial für mit reinem Wasser entwickelbare Druckplatten verwendet und weist bei hoher Lichtempfindlichkeit eine gute Lagerfähigkeit auf.

EP 0 194 587 A2

HOECHST AKTIENGESELLSCHAFT
KALLE Niederlassung der Hoechst AG



# Lichtempfindliches Diazoniumsalz-Polykondensationsprodukt und damit hergestelltes lichtempfindliches Aufzeichnungsmaterial

Die vorliegende Erfindung betrifft ein lichtempfindliches Diazoniumsalz-Polykondensationsprodukt, das zur Herstellung von vorsensibilisierten Flachdruckplatten und anderen lichtempfindlichen Materialien, z. B. Photoresists und Farbprüffolien, verwendet werden kann.

Aus der US-A 4 533 620 sind Diazoniumsalz-Mischkondensationsprodukte zur Herstellung von Flachdruckplatten bekannt, die durch Kondensation aus zwei verschiedenen aromatischen Diazoniumsalzen und Aldehyden oder bestimmten kondensierbaren aromatischen Verbindungen mit Halogenmethyl-, Hydroxymethyl- oder Alkoxymethylsubstituenten erhalten werden. Die Kondensationsprodukte ergeben Druckplatten mit hoher Lichtempfindlichkeit und guter Lagerfähigkeit. Als Diazoniumsalzanionen werden $HSO_4^-$, $H_2PO_4^-$, $Cl^-$ und $Br^-$ genannt, wenn das Produkt wasserlöslich sein soll. Für in Wasser und in organischen Lösungsmitteln lösliche Kondensationsprodukte werden als Anionen Methansulfonat, Sulfosalicylat und p-Toluolsulfonat genannt, während in organischen Lösungsmitteln lösliche Kondensate als Mesitylensulfonate oder andere Arylsulfonate, Tetrafluoroborate und Hexafluorophosphate isoliert werden.

Obwohl einige dieser Produkte in reinem Wasser löslich sind, lassen sich die damit erhaltenen Druckplatten meist nur schwierig mit reinem Wasser entwickeln.

Aufgabe der Erfindung war es, ein Diazoniumsalz-Polykondensationsprodukt der eingangs genannten Gattung vorzuschlagen, das im Hinblick auf Lagerfähigkeit und Lichtempfindlichkeit den bekannten Produkten vergleichbar ist, mit dem sich aber Druckplatten herstellen lassen, die mit reinem Wasser rückstandsfrei entwickelt werden können.

Erfindungsgemäß wird ein lichtempfindliches Polykondensationsprodukt aus wiederkehrenden Einheiten der Formeln $A_1$ und $A_2$

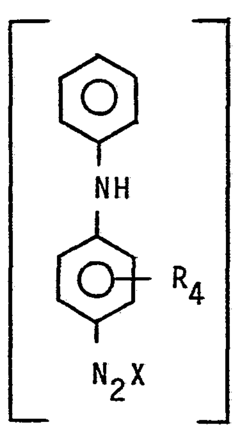 $(A_1)$ 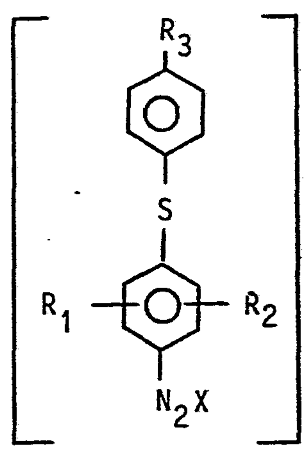 $(A_2)$

vorgeschlagen, die durch Methylengruppen miteinander verbunden sind, wobei

| | |
|---|---|
| $R_1$ und $R_2$ | Alkoxygruppen mit 1 bis 4 Kohlenstoffatomen, |
| $R_3$ | ein Wasserstoffatom oder eine Alkylgruppe und |
| $R_4$ | ein Wasserstoffatom oder eine Alkoxygruppe mit 1 bis 4 Kohlenstoffatomen bedeuten |

und im Mittel die Gesamtzahl der Einheiten $A_1$ und $A_2$ 2 bis 160 und das Verhältnis der Einheiten $A_1 : A_2$ 0,125 bis 8 : 1 beträgt.

Das erfindungsgemäße Produkt ist dadurch gekennzeichnet, daß X das Anion einer Fluoratome enthaltenden Säure ist.

Vorzugsweise ist X das Fluorid-, Tetrafluoroborat-, Hexafluorophosphat- oder Hexafluorosilikatanion.

Erfindungsgemäß wird ferner ein lichtempfindliches Aufzeichnungsmaterial aus einem Schichtträger und einer lichtempfindlichen Schicht vorgeschlagen, die als lichtempfindliche Substanz ein Polykondensationsprodukt der oben angegebenen Zusammensetzung enthält.

Als Schichtträger werden in bekannter Weise Materialien eingesetzt, die als Schichtträger für Druckplatten, insbesondere für Flachdruckplatten, bekannt sind. Hierfür kommen vor allem Metalle, wie Stahl, Chrom, Kupfer, Zink, Magnesium und vorzugsweise Aluminium in Betracht.

Die Einheiten sind in den erfindungsgemäßen Polykondensationsprodukten nicht in einer bestimmten Reihenfolge angeordnet.

Die Gesamtzahl der Einheiten $A_1$ und $A_2$ beträgt vorzugsweise 2 bis 30, und das Verhältnis ist vorzugsweise 0,5 bis 2 : 1.

Die erfindungsgemäßen lichtempfindlichen Diazoniumsalz-Polykondensationsprodukte können im Gemisch mit weiteren Bestandteilen, wie Bindemitteln, Farbstoffen, Pigmenten, Lösemitteln, Weichmachern, Netzmitteln und Säuren vorliegen, die je nach Bedarf zugefügt werden.

Die Verbindungen der vorliegenden Erfindung lassen sich allgemein als Produkte einer Kondensationsreaktion beschreiben, bei der zwei oder mehrere kondensationsfähige aromatische Diazoniumverbindungen mit Formaldehyd umgesetzt werden.

Die Reaktionsmedien sind dabei starke bis mittelstarke Säuren, insbesondere anorganische Säuren, von denen wiederum Phosphor- und Schwefelsäure bevorzugt werden.

Als monomere Diazoniumverbindungen eignen sich z. B. Diphenylamin-4-diazoniumsulfat, 3-Alkoxy-diphenylamin-4-diazoniumsulfat, 2,5-Dialkoxy-diphenylsulfid-4-diazoniumsulfat, besonders 2,5-Dialkoxy-4-(p-tolylmercapto)-benzoldiazonium-tetrachlorozinkat, wobei die Alkoxygruppen jeweils 1 bis 4, bevorzugt 1 oder 2 C-Atome haben. Als Kondensationspartner wird bevorzugt Paraformaldehyd oder eine Modifikation desselben verwendet.

HOECHST AKTIENGESELLSCHAFT
KALLE Niederlassung der Hoechst AG



Bei Verwendung von Schwefelsäure beträgt die Konzentration der Säure bevorzugt 96 %, es sind jedoch auch geringere Konzentrationen möglich. Die Temperaturen der Säure können dabei vom Gefrierpunkt der Säure bis zur Raumtemperatur reichen; bevorzugt liegen sie zwischen etwa 6 und 15 °C. Wenn die Kondensationsreaktion in Phosphorsäure durchgeführt wird, ist im allgemeinen eine Konzentration von 85 % angemessen. In einigen Fällen ist zur Erreichung des gewünschten Ergebnisses eine erhöhte Aktivität erforderlich. Dann fügt man am besten $P_2O_5$ hinzu, um die Konzentration der Phosphorsäure zu steigern. Beim Einsatz von Phosphorsäure können die Temperaturen zwischen 20 und 50 °C und insbesondere zwischen 35 und 45 °C liegen.

Die eine der zur Herstellung der erfindungsgemäßen Kondensationsprodukte verwendeten monomeren Diazoniumverbindungen ist eine Diarylsulfid-Diazoniumverbindung, die bevorzugt zwei Alkoxysubstituenten an dem Ring trägt, an dem sich die Diazoniumgruppe befindet.

Üblicherweise werden die monomeren Diazoniumverbindungen nacheinander innerhalb von 30 bis 240 Minuten in die zur Kondensation verwendete Säure gegeben, danach wird der Paraformaldehyd langsam eingetragen, so daß Temperaturschwankungen vermieden werden. Die Reaktionszeit beträgt im allgemeinen 15 bis 300 Minuten, bevorzugt 30 bis 240 Minuten. Es ist eine Nachreaktionszeit unter isothermen Bedingungen angezeigt, um die volle Umsetzung der Reaktionsteilnehmer sicherzustellen. Die Dauer der Nachreak-

HOECHST AKTIENGESELLSCHAFT
KALLE Niederlassung der Hoechst AG



tion kann zwischen 1/2 und 48 Stunden betragen. Bevorzugt beträgt sie 10 bis 30, insbesondere 12 bis 20 Stunden.

Das erhaltene Kondensationsgemisch wird langsam unter Rühren in die 5- bis 10-fache Menge Wasser gegossen. Dazu wird langsam die äquivalente Menge einer Fluor enthaltenden Säure oder eine Lösung ihres Salzes getropft, wodurch das Reaktionsprodukt als gelbes, festes Produkt ausfällt und isoliert werden kann. Bevorzugt verwendet man wäßrige Lösungen von NaF, $HBF_4$, $NaBF_4$, $H_2SiF_6$ oder $HPF_6$.

Lichtempfindliche Gemische, die zur Herstellung von lichtempfindlichen Materialien wie Flachdruckplatten, Photoresists oder Farbprüffolien verwendet werden, bestehen in der Regel aus einem Gemisch aus aromatischen Diazoniumsalzen, Bindemitteln, Farbstoffen oder Pigmenten, Indikatoren und Stabilisatoren, das auf einen geeigneten Träger, der im allgemeinen aus Aluminium besteht, aufgetragen wird.

Die erfindungsgemäße Diazoniumverbindung kann ebenso wie die bekannten in organischen Lösemitteln verarbeitet werden. Die Menge der Diazoniumverbindung liegt zwischen 15 und 100, bevorzugt zwischen 20 und 80 Gew.-%, bezogen auf Feststoffe.

Der Diazoniumverbindung können Bindemittel zugesetzt werden, um die Druckauflage zu erhöhen. Zu solchen Bindemitteln gehören z. B. Polyvinylacetat-Maleinat-Copolymere, Polyvinylalkyläther, Polyurethane, Polyvinylacetale, Polyole, Polyacrylate, Polyvinylacetate und Phenolformaldehydharze. Sie werden gewöhnlich in Mengen zwischen 5 und 75, bevorzugt zwischen 15 und 60 Gew.-%, bezogen auf den Feststoffgehalt des Beschichtungsgemischs, eingesetzt.

Als Farbmittel dienen gewöhnlich Pigmente oder Farbstoffe. Zu den geeigneten Farbstoffen gehören Triarylmethan- und Xanthenfarbstoffe. Der Farbmittelanteil liegt zwischen 1 und 10, bevorzugt zwischen 2 und 7 Gew.-%.

Im folgenden wird die Erfindung anhand von Beispielen näher erläutert. Prozentangaben und Mengenverhältnisse sind auf das Gewicht bezogen.

<u>Herstellungsbeispiel 1</u> (Vergleich)

8,8 g Diphenylamin-4-diazoniumsulfat und 59 g 2,5-Dimethoxy-4-p-tolylmercapto-benzoldiazoniumtetrachlorozinkat werden zu 223 g Schwefelsäure (96 %) gegeben. Sobald alles unter gleichmäßigem Rühren bei 10 °C völlig gelöst ist, werden innerhalb von 3 Stunden 4,5 g Paraformaldehyd langsam hinzugefügt. Während dieser Zeit muß auf eine gleichbleibende Temperatur geachtet werden. Dann wird noch 10 Stunden bei 10 °C gerührt. Danach wird das Reaktionsgemisch in 2 l entionisiertem Wasser gelöst und als p-Toluolsulfonat ausgefällt.

Herstellungsbeispiel 2

Man kondensiert wie in Beispiel 1. Statt als p-Toluolsulfonat auszufällen, werden zu der mit Wasser verdünnten Reaktionslösung langsam 54 g Tetrafluoroborsäure (32 %ig) zugetropft. Das Reaktionsprodukt fällt aus und wird isoliert.

Anwendungsbeispiel 1

Von den beiden Reaktionsprodukten nach Herstellungsbeispiel 1 (Vergleich) und Herstellungsbeispiel 2 (erfindungsgemäß) werden lichtempfindliche Beschichtungslösungen wie folgt hergestellt:

1,50 % Diazoniumsalz-Polykondensat
0,15 % Farbstoff Basonylrot 540
0,40 % $H_3PO_4$ (85 %)
97,97 % 2-Methoxy-ethanol

Beide Lösungen werden zum Vergleich auf je eine elektrochemisch aufgerauhte, anodisch oxidierte und nach bekannten Verfahren hydrophilierte Al-Platte aufgeschleudert. Nach dem Trocknen werden beide Platten nebeneinander unter einer Metallhalogenidlampe belichtet.

Mit einem Teil jeder Platte wird die restlose Entwicklung mit reinem Wasser geprüft, mit dem anderen Teil die Lagerfähigkeit im unbelichteten Zustand.

Um die Entwickelbarkeit mit reinem Wasser ohne manuelles Überwischen bzw. Reiben mit Schwamm, Wattebausch oder

ähnlichem zu prüfen, werden die beiden Plattenhälften nach Herstellungsbeispiel 1 und 2 nebeneinander mit einer Wasserbrause kurz abgespült und getrocknet. Die so entwickelten Platten werden ohne Vorlage nebeneinander nochmals die dreifache Zeit, die für die Bildbelichtung nötig ist, belichtet, angefeuchtet und mit fetter Farbe von Hand oder in einer Offsetdruckmaschine eingefärbt. Man erkennt, daß die Schicht nach Herstellungsbeispiel 1 auch an den bildfreien Stellen deutlich Farbe annimmt, d. h. sie läßt sich mit der Wasserbrause nicht restlos entwickeln. Die Schicht nach Herstellungsbeispiel 2 ist dagegen nach Behandlung mit fetter Farbe völlig tonfrei, d. h. sie kann allein mit der Wasserbrause restlos entwickelt werden.

Zur Prüfung der Lagerfähigkeit des unbelichteten Plattenmaterials ist ein Schnelltest durch Lagerung bei 100 °C gut geeignet. Dazu werden mehrere Platten nach den Herstellungsbeispielen 1 und 2 nebeneinander in einem auf 95 bis 110 °C geheizten Trockenschrank gelagert. Alle 10 Minuten wird je eine Platte entnommen, nach dem Abkühlen wie üblich unter einer Testfilmvorlage belichtet, mit der Wasserbrause ohne manuelles Überwischen kurz entwickelt und mit fetter Farbe überwischt. An dem länger werdenden mitkopierten fotografischen Stufenkeil, dem Auftreten eines Farbschleiers und schließlich der Farbannahme an den bildfreien Stellen mit zunehmender Lagerzeit erkennt man die Lagerfähigkeit der Materialien. Bei dem vorliegenden Vergleich sind die Platten nach Herstellungsbeispiel 1 nur 60 bis 80 Minuten bei 100 °C lagerfähig, die erfindungsgemäßen jedoch 160 bis 200 Minuten.

H O E C H S T   A K T I E N G E S E L L S C H A F T
KALLE Niederlassung der Hoechst AG



Das entspricht einem Unterschied in der Lagerfähigkeit bei Raumtemperatur von mehreren Monaten.

Ein besonderer Vorteil der erfindungsgemäßen Schicht liegt darin, daß sie trotz der wesentlich besseren Lagerfähigkeit ebenso lichtempfindlich wie die Vergleichsschicht ist. Lichtempfindlichkeit und Lagerfähigkeit sind hier also nicht reziprok, wie sonst allgemein angenommen wird und vielfach in der Fachliteratur beschrieben ist.

<u>Anwendungsbeispiel 2</u>

Man stellt eine lichtempfindliche Beschichtungslösung wie folgt her:

| | |
|---|---|
| 1,50 % | Diazoniumsalz-Polykondensat nach Herstellungsbeispiel 2 |
| 0,15 % | Kristallviolett |
| 0,60 % | $H_3PO_4$ (85 %) |
| 0,50 % | Vinylacetat-Maleinat-Copolymerisat |
| 97,25 % | 2-Methoxy-ethanol |

Man beschichtet, belichtet und entwickelt wie im Anwendungsbeispiel 1 angegeben. Die Lagerfähigkeit bei 100 °C beträgt 160 bis 180 Minuten. An einer handelsüblichen Offsetdruckmaschine werden 130.000 gute Drucke erhalten.

Mit gleichem Erfolg kann man statt des angegebenen Copolymerisats als Bindemittel einen Polyvinylethylether oder ein Copolymerisat aus Ethylacrylat, Methylmethacrylat, Acrylsäure und Methacrylsäure einsetzen.

HOECHST AKTIENGESELLSCHAFT
KALLE Niederlassung der Hoechst AG



Herstellungsbeispiel 3

6 g Diphenylamin-4-diazoniumsulfat und 41,8 g 2,5-Diethoxy-4-p-tolylmercapto-benzoldiazoniumtetrachlorozinkat werden zu 150 g Schwefelsäure (96 %) gegeben. Wenn alles bei + 10 °C gelöst ist, werden innerhalb 2 Stunden 3,0 g Trioxan langsam hinzugefügt. Man rührt noch 17 Stunden bei + 10 °C, gießt das Rohprodukt in 1,3 l Wasser und tropft unter Rühren 200 g $H_2SiF_6$ (34 %ig) zu. Das Reaktionsprodukt fällt als gelber Feststoff aus, wird abfiltriert und getrocknet.

Anwendungsbeispiel 3

Man stellt eine lichtempfindliche Beschichtungslösung aus folgenden Komponenten her:

| | |
|---|---|
| 1,50 % | Diazoniumsalz-Polykondensat gemäß Herstellungsbeispiel 3, |
| 0,15 % | Astrazonrotviolett 3 RN |
| 0,40 % | $H_3PO_4$ (85 %) |
| 87,95 % | 2-Methoxy-ethanol |
| 10,00 % | Butyrolacton |

Man beschichtet damit eine durch Bürsten mit einer wäßrigen Schleifmittelsuspension aufgerauhte Al-Platte, belichtet unter einem photographischen Negativ und entwickelt mit reinem Wasser. Nach dem Einfärben mit fetter Farbe erhält man eine einwandfreie Druckform.

H O E C H S T   A K T I E N G E S E L L S C H A F T
KALLE Niederlassung der Hoechst AG



Herstellungsbeispiel 4

Man kondensiert wie im Herstellungsbeispiel 3. Statt $H_2SiF_6$ werden zu der mit Wasser verdünnten Reaktionslösung langsam unter Rühren 50 g Natriumfluorid zugegeben. Das Kondensationsprodukt fällt nach dem Sättigen mit Kochsalz als gelber Feststoff aus und kann gut isoliert werden.

Herstellungsbeispiel 5

Man kondensiert wie im Herstellungsbeispiel 1, fällt aber das Kondensationsprodukt mit 50 g $NaBF_4$ in wäßriger Lösung als grünlichen Feststoff aus.

Anwendungsbeispiele 4 und 5

Eine mit der Beschichtungslösung von Anwendungsbeispiel 3, aber mit dem Kondensationsprodukt von Herstellungsbeispiel 4 als lichtempfindliche Verbindung beschichtete, durch Bürsten mit einer wäßrigen Schleifmitteldispersion aufgerauhte und anodisierte Al-Platte wird nach der Belichtung unter einer Vorlage mit Wasser entwickelt und kann für den Druck sauber eingefärbt werden.

Eine weitere Aluminiumplatte wird wie in Anwendungsbeispiel 2, aber mit dem Kondensationsprodukt von Herstellungsbeispiel 5, beschichtet und unter einer Vorlage belichtet. Die Platte wird bei gedämpftem Licht in eine Druckmaschine gespannt. Nach dem Anlaufen der Maschine ist die Platte sofort entwickelt, nimmt Farbe an den Bildstellen an und leistet ca. 50 000 Drucke.

HOECHST AKTIENGESELLSCHAFT
KALLE Niederlassung der Hoechst AG



## Patentansprüche

1. Lichtempfindliches Polykondensationsprodukt aus wiederkehrenden Einheiten der Formeln $A_1$ und $A_2$,

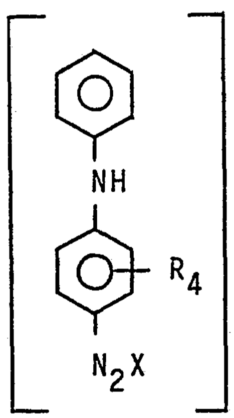 $(A_1)$ 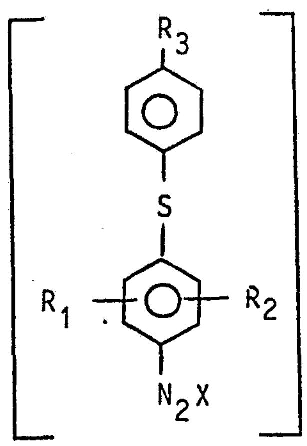 $(A_2)$

die durch Methylengruppen miteinander verbunden sind, wobei

$R_1$ und $R_2$ Alkoxygruppen mit 1 bis 4 Kohlenstoffatomen,
$R_3$ ein Wasserstoffatom oder eine Alkylgruppe und
$R_4$ ein Wasserstoffatom oder eine Alkoxygruppe mit 1 bis 4 Kohlenstoffatomen bedeuten

und im Mittel die Gesamtzahl der Einheiten $A_1$ und $A_2$ 2 bis 160 und das Verhältnis der Einheiten $A_1 : A_2$ 0,125 bis 8 : 1 beträgt, dadurch gekennzeichnet, daß

X das Anion einer Fluoratome enthaltenden Säure ist.

H O E C H S T   A K T I E N G E S E L L S C H A F T
KALLE Niederlassung der Hoechst AG



2. Polykondensationsprodukt nach Anspruch 1, dadurch gekennzeichnet, daß X das Fluorid-, Tetrafluoroborat-, Hexafluorophosphat- oder Hexafluorosilikatanion ist.

3. Lichtempfindliches Aufzeichnungsmaterial aus einem Schichtträger und einer lichtempfindlichen Schicht, die als lichtempfindliche Substanz ein Polykondensationsprodukt gemäß Anspruch 1 enthält.

4. Aufzeichnungsmaterial nach Anspruch 3, dadurch gekennzeichnet, daß die lichtempfindliche Schicht ferner ein polymeres Bindemittel enthält.

5. Aufzeichnungsmaterial nach Anspruch 3, dadurch gekennzeichnet, daß der Schichtträger aus Aluminium besteht.